# EUROPÄISCHE PATENTSCHRIFT

(11) **EP 1 825 493 B1**
(45) Veröffentlichungstag und Bekanntmachung des Hinweises auf die Patenterteilung: **21.11.2012**
(21) Anmeldenummer: 05817910.2
(22) Anmeldetag: 09.12.2005
(51) Int. Cl.: H01J 37/32

(54) **Verfahren und Vorrichtung zum Betrieb einer Plasmaeinrichtung**
Method and device for operating a plasma device
Procédé et dispositif pour faire fonctionner un dispositif à plasma

(30) Priorität: 15.12.2004 DE 102004060377
(43) Veröffentlichungstag der Anmeldung: 29.08.2007
(73) Patentinhaber: Max-Planck-Gesellschaft zur Förderung der Wissenschaften e.V., 80539 München (DE)
(72) Erfinder: MORFILL, Gregor, 81927 München (DE); THOMAS, Hubertus, M., 85276 Pfaffenhofen (DE); KONOPKA, Uwe, 85375 Neufahrn (DE); JACOB, Wolfgang, 85748 Garching (DE); ANNARATONE, Beatrice, 81925 München (DE); FINK, Martin, 85375 Mintraching (DE); SATO, Noriyoshi, Sendai 980-0815 (JP); SHIMIZU, Tetsuji, 85748 Garching; (DE); STUFFLER, Timo, 82229 Seefeld (DE)
(74) Vertreter: Hertz, Oliver
(86) Internationale Anmeldenummer: PCT/EP2005/013233
(87) Internationale Veröffentlichungsnummer: WO 2006/063738

(56) Entgegenhaltungen:
- EP-A- 0 392 678
- EP-A- 0 425 419
- WO-A-01/01467
- US-A- 5 350 454
- PATENT ABSTRACTS OF JAPAN Bd. 2003, Nr. 12, 5. Dezember 2003 (2003-12-05) & JP 2004 259832 A (SHARP CORP), 16. September 2004 (2004-09-16)

## Beschreibung

Die vorliegende Erfindung betrifft Verfahren zum Betrieb einer Plasmaeinrichtung, wie zum Beispiel zur plasmabasierten Materialabscheidung oder Oberflächenbearbeitung, und insbesondere Verfahren zur Manipulation von Partikeln in einer Plasmaeinrichtung. Die vorliegende Erfindung betrifft auch Plasmaeinrichtungen, die zur Umsetzung derartiger Verfahren eingerichtet sind.

Es ist allgemein bekannt, dass in einem Gas, in dem durch eine elektrische Entladung ein Plasmazustand erzeugt wird, Partikel vorhanden sein können. Die Partikel werden bspw. gezielt von außen in das Plasma eingeführt oder in diesem durch eine vorbestimmte Prozessführung erzeugt (siehe z. B. "Dusty Plasmas: Physics, Chemistry and Technological Impact in Plasma Processing" (ed. A. Bouchoule), J. Wiley & Sons, 1999). In diesem Fall kann insbesondere eine Untersuchung oder Manipulation der Partikel im Plasma erwünscht sein. Bei der Untersuchung der Partikel soll bspw. eine Wechselwirkung von Partikeln (z. B. bei der Erzeugung von sog. Plasmakristallen) oder die Entstehung oder das Wachstum der Partikel charakterisiert werden. Die Manipulation von Partikel kann bspw. eine Partikelbearbeitung im Plasma (Oberflächenabtrag oder Oberflächenabscheidung) oder die Ablage der Partikel auf Substraten umfassen, wie dies bspw. bei der gesteuerten Abscheidung polymorpher Schichten der Fall ist (Cabarrocas et al. J. of Non-Crystalline Solids 227-230 (1998) 871-875). Bei der Abscheidung polymorpher Schichten kann ein Interesse daran bestehen, Partikel mit einer bestimmten Partikelgrößenverteilung auf einem Substrat abzuscheiden oder zu deponieren. Ein praktikables Verfahren zur Einstellung einer Partikelgrößenverteilung ist jedoch bisher nicht verfügbar.

Alternativ können die Partikel im Plasma oder auf einem Substrat eine unerwünschte Kontamination darstellen. Beispielsweise werden bei der Herstellung von Solarzellen, Wafern oder Komponenten für die Flachbildschirmtechnik durch Plasmaabscheidung die Qualität und die Ausfallrate der Produkte wesentlich dadurch bestimmt, inwieweit störende Partikel von den zu beschichtenden Substraten ferngehalten werden können. Partikel können auf dem Substrat lokale Entladungen und dadurch Löcher in der Schicht verursachen, durch die z. B die Bildqualität eines Flachbildschirms vermindert wird.

Eine Ursache der Substratkontamination besteht darin, dass nach einem Beschichtungsvorgang, wenn das Plasma in einem Plasmareaktor abgeschaltet wird, die im Plasma gebildeten Partikel mit typischen Dimensionen im nm- bis µm-Bereich eine elektrische Nettoladung (typischerweise negative Ladung) tragen, während die Substratoberfläche eine entgegengesetzte Ladung aufweist. Dies führt zu einer bisher unvermeidbaren Partikelbewegung zur Substratoberfläche, selbst wenn die Plasmabeschichtung an vertikal ausgerichteten Substraten erfolgt (Ivlev et al. "Decharging of Complex Plasmas: First Kinetic Observations" in "Phys. Rev. Lett.", Band 90, Seite 5). Die genannten Probleme treten insbesondere bei der Plasmaabscheidung auf großen Substraten mit typischen Durchmessern im dmbis m-Bereich auf.

Sowohl bei den Anwendungen zur Untersuchung oder Manipulation von Partikeln im Plasma als auch bei der Partikelkontamination besteht generell ein Interesse, auf die Lage, Verteilung und/oder Bewegung der Partikel im Plasma in vorbestimmter Weise einzuwirken. Hierzu wird in WO 99/52125 vorgeschlagen, in einem Plasmareaktor mit Zusatzelektroden oder unter Verwendung einer sog. adaptiven Elektrode mit einer Vielzahl von Teilelektroden das elektrische Feld statisch oder mit niedriger Frequenz derart einzustellen oder zu verändern, dass die Partikel über dem Substrat im Plasmareaktor eine bestimmte räumliche Verteilung einnehmen. Nachteilig an dieser Technik kann jedoch sein, dass die genannten Ziele, Partikel im Plasma zu untersuchen oder zu manipulieren oder Partikelkontaminationen aus dem Plasma zu entfernen, nur beschränkt gelöst werden können und dass die Deposition auf dem Substrat die Struktur der Elektroden wiedergibt.

JP 2004 259832 A offenbart eine gattungsgemäße Plasmaeinrichtung mit einer Wanderwellenelektrode, die Streifenelektroden umfasst und zur Erzeugung von elektrischen Wanderwellen eingerichtet ist. Staubpartikel in der Plasmaeinrichtung können unter der Wirkung der Wanderwellen von einem Substrat entfernt werden.

Die Aufgabe der Erfindung ist es, ein verbessertes Verfahren zum Betrieb einer Plasmaeinrichtung bereitzustellen, mit dem die Nachteile der herkömmlichen Techniken zur Untersuchung oder Manipulation von Partikeln im Plasma überwunden werden und das insbesondere eine zuverlässige und gezielte Bewegung von Partikeln im Plasma ermöglicht. Das erfindungsgemäße Verfahren soll insbesondere einen erweiterten Anwendungsbereich besitzen und neue Möglichkeiten zur Beeinflussung der Partikel im Plasma eröffnen. Die Aufgabe der Erfindung ist es auch, eine verbesserte Plasmaeinrichtung bereitzustellen, mit der die Nachteile der herkömmlichen Plasmareaktoren überwunden werden und die zur Beeinflussung von Partikeln im Plasma geeignet ist.

Diese Aufgabe wird durch ein Verfahren und eine Plasmaeinrichtung mit den Merkmalen der Ansprüche 1 und 16 gelöst. Vorteilhafte Ausführungsformen und Anwendungen der Erfindung ergeben sich aus den abhängigen Ansprüchen.

Verfahrensbezogen basiert die Erfindung auf der allgemeinen technischen Lehre, in einer Plasmaeinrichtung elektrische Wanderwellen zu erzeugen, durch die auf Partikel im Plasma Kräfte ausgeübt werden, so dass sich die Partikel gerichtet zu mindestens einem vorbestimmten Sammlungsbereich in der Plasmaeinrichtung bewegen. Vorteilhafterweise verursachen die elektrischen Wanderwellen einen Partikeltransport mit einem Nettostrom von Partikel hin zu dem Sammlungsbereich. Die Wanderwellen ermöglichen im Gegensatz zu herkömmlichen Techniken, bei denen lediglich eine Positionierung oder Umverteilung von Partikeln ohne einen Nettostrom vorgesehen war, eine kontinuierliche Partikelbewegung während und/oder nach der Ausbildung des Plasmas. Damit können vorteilhafterweise Partikel, die im Plasma z. B. während einer Plasmaabscheidung laufend nachgebildet werden, ständig aus einem Plasmaraum, insbesondere aus der Nähe eines zu beschichtenden Substrates entfernt werden. Im Ergebnis können Kontaminationen vermieden und Schichten mit einer erheblich verbesserten Homogenität produziert werden. Die genannten Qualitätsverluste und Geräteausfälle der resultierenden Produkte können reduziert und/oder die Plasmabedingungen für einen Fertigungsprozess optimiert werden.

Vorteilhafterweise können die elektrischen Wanderwellen ohne Einschränkung den gesamten Plasmaraum durchlaufen, so dass der Partikeltransport auch über ausgedehnten Substraten zuverlässig erfolgt, wie sie bspw. in der Halbleiter- oder Solarzellentechnik beschichtet werden.

Die Plasmaeinrichtung umfasst allgemein ein Gerät mit einem evakuierbaren Innenraum, insbesondere mit einer Plasmakammer, der mit einem Betriebsgas zur Plasmaerzeugung gefüllt und mit elektrischen Feldern zum Zünden einer Plasmaentladung beaufschlagt werden kann. Eine elektrische Wanderwelle wird durch eine sich im Zeitverlauf, vorzugsweise periodisch wiederholt in einer bestimmten Richtung bewegende elektrische Feldverteilung (Wanderfeld) erzeugt. Erfindungsgemäß können eine Wanderwelle mit einer vorbestimmten Richtung oder mehrere Wanderwellen mit verschiedenen, vorbestimmten Richtungen, zum Beispiel zwei relativ zueinander entgegengesetzt laufende Wanderwellen erzeugt werden. Durch die elektrische Wechselwirkung mit dem Feld der Wanderwelle führen die Partikel eine gerichtete Bewegung aus, d. h. sie werden in einer Richtung parallel zur Laufrichtung der Wanderwelle verschoben. Der Begriff "gerichtete Bewegung" kann Bewegungen wenigstens von Teilen einer Partikelmenge jeweils in mehrere Richtungen einschließen, wenn mehrere Wanderwellen mit verschiedenen Laufrichtungen erzeugt werden.

Gemäß der Erfindung werden die elektrischen Wanderwellen mit einer Vielzahl von Streifenelektroden erzeugt, die nebeneinander in der Plasmaeinrichtung angeordnet und mit einer oder mehreren Wechselspannungen (Sammlungswechselspannung) beaufschlagt werden. Die Verwendung der Streifenelektroden besitzt den Vorteil einer hohen Flexibilität bei der Erzeugung der Wanderwellen. Die Parameter der elektrischen Wanderwellen, insbesondere die Wellenform, Frequenz und Amplituden können mit geringem Aufwand an die Eigenschaften der Partikel, die transportiert oder deponiert (abgeschieden) werden sollen, wie z. B. an deren Größe oder dielektrischen Eigenschaften angepasst werden. Des Weiteren können die Streifenelektroden problemlos in einer bestehenden Plasmaeinrichtung angeordnet werden, ohne deren Funktion, wie z. B. die Beschichtung eines Substrates zu beeinträchtigen. Vorteilhafterweise können mit den Streifenelektroden Wanderwellen erzeugt werden, die entlang dem longitudinalen Verlauf der Streifenelektroden gleichförmig sind und deren Laufrichtung durch die Anordnungsrichtung der Streifenelektroden festgelegt ist.

Weitere Vorteile für die Erzeugung der Wanderwellen können sich ergeben, wenn alle Streifenelektroden mit einer gemeinsamen Sammlungswechselspannung beaufschlagt werden, dies jedoch jeweils mit einer vorbestimmten Verzögerung oder Phasenverschiebung. Die Beaufschlagung der Streifenelektroden mit jeweils spezifischen Phasenverschiebungen bedeutet, dass Streifenelektroden, die entsprechend der gewünschten Bewegungsrichtung der Partikel zum Sammlungsbereich aufeinanderfolgend benachbart angeordnet sind, mit der Sammlungswechselspannung mit einer Zeitverzögerung beaufschlagt werden, so dass die in der gewünschten Bewegungsrichtung der Partikel fortschreitende Wanderwelle erzeugt wird.

Das erfindungsgemäße Verfahren besitzt vorteilhafterweise eine hohe Variabilität bei der Auswahl der Sammlungswechselspannung oder deren Anpassung an die Bedingungen der jeweiligen praktischen Anwendung. Gemäß einer ersten Variante kann die Sammlungswechselspannung mit einem symmetrischen Spannungsverlauf bereitgestellt werden. Die Zeitabhängigkeit der Sammlungswechselspannung ist in diesem Fall durch zwei zueinander spiegelsymmetrische Flanken innerhalb einer Periode charakterisiert. Diese Ausführungsform der Erfindung ermöglicht vorteilhafterweise, dass an sich verfügbare Wechselspannungsquellen zur Bereitstellung der Sammlungswechselspannung verwendet werden können. Die Wanderungsgeschwindigkeit der Amplitudenmaxima der Sammlungswechselspannung wird vorzugsweise in Abhängigkeit von der Größe und dem Material der Partikel so gewählt, dass die transportierten Partikel mit den Vorderflanken der Wanderwellen mitgenommen werden. Besonders bevorzugt sind in diesem Fall Spannungsquellen, die sinusförmige oder pulsförmige Spannungsverläufe liefern.

Gemäß einer alternativen Variante besitzt die Sammlungswechselspannung einen asymmetrischen Spannungsverlauf. Dies bedeutet, dass innerhalb einer Periode die ansteigenden und abfallenden Flanken jeweils verschiedene Steilheiten besitzen. Bei dieser Ausführungsform der Erfindung besitzt die Wanderwelle vorteilhafterweise die Form eines Rampenprofils, das sich über die Streifenelektroden bewegt und unter dessen Wirkung die Partikel zum Sammlungsbereich transportiert werden. Vorzugsweise besitzt die vordere Flanke die geringere Steilheit, so dass relativ viel Zeit für eine wirksame Kraftausübung auf die Partikel gegeben ist, während die rückseitige Flanke steiler abfällt. Beim Durchlauf der rückseitigen Flanke erfolgt wegen der Partikelträgheit bei größeren Partikeln kaum eine Rückwärts-Bewegung, so dass nur größere Partikel selektiv im Plasma transportiert werden.

Vorteilhafterweise kann die Sammlungswechselspannung innerhalb einer Periode eine Trapezform besitzen. Dies bedeutet, dass zwischen den ansteigenden und abfallenden Flanken jeweils ein Gleichspannungsabschnitt gegeben ist. Diese Ausführungsform der Erfindung besitzt den Vorteil, dass die Steilheit der Flanken frei einstellbar ist, ohne dass die Periode (oder Frequenz) der Sammlungswechselspannung verändert werden muss.

Die asymmetrische Form der Wanderwelle besitzt den besonderen Vorteil, dass mit der Einstellung der Wellenform, insbesondere mit der Einstellung der Steilheit und/oder der Dauer der Flanken eine Größenselektion der erfindungsgemäßen transportierten Partikel erfolgen kann. Je größer die Partikel sind, desto langsamer muss sich die Flanke der Sammlungswechselspannung ändern, damit ein wirksamer Partikeltransport erzielt wird. Dies ermöglicht, dass die Wellenform durch wenigstens eine der Maßnahmen, die eine Erhöhung der Frequenz der Sammlungswechselspannung, eine Vergrößerung der Steilheit und eine Verkürzung der Flanken der Sammlungswechselspannung umfassen, nur solche Partikel dem erfindungsgemäßen Transport unterzogen werden, deren Größe eine vorbestimmte Maximalgröße nicht übersteigt.

Wegen des genannten Zusammenhangs zwischen der Frequenz und/oder Form der Wanderwellen und der Größe erfindungsgemäß transportierbaren Partikel wird die Sammlungswechselspannung bei einer Ausführungsform der Erfindung, bei der das Plasma in der Plasmaeinrichtung durch eine hochfrequente Betriebswechselspannung erzeugt wird, mit einer Frequenz bereitgestellt, die geringer als die Frequenz der Betriebswechselspannung ist. Erfindungsgemäß wird eine Frequenz der Sammlungswechselspannung im Bereich von 0.01 Hz bis 10 Hz, insbesondere von 0.1 Hz bis 10 Hz gewählt, wobei jedoch auch bei höheren Frequenzen (z. B. 100 Hz oder höher) der erfindungsgemäße Partikeltransport einstellbar ist.

Wenn gemäß einer bevorzugten Ausführungsform der Erfindung die Streifenelektroden sowohl mit der Sammlungswechselspannung als mit einer Betriebsspannung der Plasmaeinrichtung zur Bildung des Plasmas beaufschlagt werden, können sich weitere Vorteile für den praktischen Betrieb der Plasmaeinrichtung ergeben. Erstens werden durch die Überlagerung der Sammlungswechselspannung und der Betriebsspannung die Partikel gerade dort, wo sie vorrangig entstehen, den elektrischen Wanderwellen ausgesetzt. Zweitens wird der Aufbau der Plasmaeinrichtung vereinfacht, da für die Erzeugung des Plasmas keine gesonderte Elektrode erforderlich ist. Bei dieser Ausführungsform der Erfindung werden alle Streifenelektroden mit der Betriebsspannung der Plasmaeinrichtung beaufschlagt, die mit der Sammlungswechselspannung überlagert ist. Die Betriebsspannung kann je nach Betriebsart der Plasmaeinrichtung eine Gleichspannung oder eine Hochfrequenzspannung sein. Alternativ kann in der Plasmaeinrichtung zusätzlich zu den Streifenelektroden mindestens eine separate Leistungselektrode vorgesehen sein, die mit der Betriebsspannung der Plasmaeinrichtung zur Plasmabildung beaufschlagt wird. Diese Ausführungsform der Erfindung weist den Vorteil auf, dass von den Streifenelektroden nur zwei Funktionen, insbesondere die Wanderwellenerzeugung und eine Homogenisierung des elektrischen Feldes (s. unten), übernommen werden, während die Leistungselektrode zum Betrieb des Plasmaprozesses vorgesehen ist.

Bei der Überlagerung der Sammlungswechselspannung und der Betriebsspannung der Plasmaeinrichtung können die elektrischen Wanderwellen vorteilhafterweise während der Erzeugung des Plasmas kontinuierlich erzeugt werden. Alternativ ist eine gesonderte Bereitstellung der Sammlungswechselspannung (überlagert mit einer Gleichspannung) möglich, mit der der Partikeltransport nur während vorbestimmter Sammlungszeiten vor oder nach der Erzeugung des Plasmas erfolgt.

Gemäß einer weiteren bevorzugten Ausführungsform der Erfindung wird die Sammlungswechselspannung mit einer höherfrequenten Modulationsspannung überlagert. Diese Überlagerung ermöglicht vorteilhafterweise eine zeitlich gemittelte Homogenisierung des Plasmas. Unter der Wirkung der Modulationsspannung werden Ionen im Plasma bewegt, während die wesentlich größeren Partikel unbeeinflusst bleiben. Damit können die Ionen gleichförmiger verteilt werden, was insbesondere bei der plasmabasierten Materialabscheidung auf Substraten von Vorteil ist. Die Parameter der bspw. sinusförmigen Modulationsspannung werden insbesondere in Abhängigkeit von den geometrischen Eigenschaften der Elektrodenstreifen (insbesondere Streifenbreite) und der Wellenform der Wanderwelle sowie in Abhängigkeit von der Konzentration und Energie der Ionen im Plasma gewählt. Die Amplitude der Modulationsspannung wird vorzugsweise so gewählt, dass im Verlauf einer halben Periode der Modulationsspannung Ionen über eine Strecke entsprechend der halben Schrittweite zwischen den Elektrodenstreifen transportiert werden können.

Die Frequenz der Modulationsspannung wird in Abhängigkeit von den praktischen Betriebsbedingungen der Plasmaeinrichtung gewählt. Wenn die Streifenelektroden gemäß der o. g. Ausführungsform der Erfindung sowohl mit der Sammlungswechselspannung als auch mit der Betriebsspannung beaufschlagt werden, wird die Frequenz der Modulationsspannung vorzugsweise im kHz-Bereich, insbesondere im Bereich von 0.1 kHz bis 100 kHz gewählt. Bei der abgewandelten Ausführungsform mit getrennten Streifen- und Leistungselektroden hingegen wird die Frequenz der Modulationsspannung im kHz- bis MHz-Bereich, insbesondere im Bereich von 10 kHz bis 1 MHz gewählt.

Für ein sicheres Auffangen der transportierten Partikel im Sammlungsbereich kann es vorteilhaft sein, wenn gemäß einer weiteren Modifikation der Erfindung der mindestens eine Sammlungsbereich jeweils eine Hohlkathode aufweist. Die Hohlkathode ist an sich bekannt (siehe: Y. Kurimoto et al. in "Film Solid Film", Bd. 457, 2004, Seite 285-291, und WO 01/01467). Ihre Verwendung besitzt den Vorteil, dass die Partikel im Sammlungsbereich unter der Wirkung elektrischer Felder festgehalten werden. Die Partikel können gesammelt und wieder verwendet werden.

Alternativ oder zusätzlich kann der Sammlungsbereich durch eine Anreicherungszone gebildet werden, in der die Partikel im schwebenden Zustand im Plasma angereichert werden. Die Bildung einer Anreicherungszone in der Plasmakammer kann für die Untersuchung von Partikelwolken oder für die Deposition großer Partikelmengen auf Substraten von Vorteil sein.

Gemäß einer weiteren Variante der Erfindung können die elektrischen Wanderwellen mit verschiedenen, insbesondere zueinander entgegengesetzten Richtungen erzeugt werden, so dass die Partikel gerichtete Bewegungen zu mindestens zwei vorbestimmten Sammlungsbereichen ausführen. Vorteilhafterweise kann damit eine materialspezifische oder größenspezifische Sammlung der Partikel in verschiedenen Sammlungsbereichen erfolgen. Die Bewegungen in die verschiedenen Richtungen können gleichzeitig oder zeitlich getrennt, zum Beispiel aufeinanderfolgend realisiert werden.

Ein weiterer wichtiger Vorteil der Erfindung ist in der Variabilität bei der Gestaltung der Bewegungsrichtung der Partikel gegeben. Die Wanderwellen können sich in einer vorgegebenen Richtung linear bewegen, die im Wesentlichen senkrecht zur Ausdehnung planar angeordneter Streifenelektroden verläuft. Alternativ kann eine Kreisbewegung mit Streifenelektroden induziert werden, die am äußeren Umfang einer Plasmakammer kreisförmig angeordnet sind.

Vorrichtungsbezogen wird die o. g. Aufgabe durch die allgemeine technische Lehre gelöst, eine Plasmaeinrichtung, die zur Bildung eines Plasmas vorgesehen ist, mit mindestens einer Elektrode zur Erzeugung von elektrischen Wanderwellen zum gerichteten Transport von Partikeln in der Plasmaeinrichtung und mindestens einem Sammlungsbereich zur Aufnahme der Partikel auszustatten. Die erfindungsgemäße Kombination von mindestens einer Elektrode zur Erzeugung von Wanderwellen (im Folgenden: Wanderwellenelektrode) und mindestens einem Sammlungsbereich ermöglicht in vorteilhafter Weise die gezielte Entfernung von Partikeln aus dem Plasma und insbesondere aus einem schichtförmigen Raumbereich oberhalb eines Substrats in der Plasmaeinrichtung.

Die Wanderwellenelektrode umfasst vorzugsweise eine Vielzahl von Streifenelektroden, die jeweils mit einer Spannungsquelle zur Erzeugung der Sammlungswechselspannung verbunden sind. Die Streifenelektroden sind vorzugsweise in einer Ebene angeordnet, so dass die Wanderwellenelektrode vorteilhafterweise unmittelbar benachbart zu einem Substrat auf dessen relativ zum Plasma entgegengesetzten Seite angeordnet werden kann.

Die Streifenelektroden der Wanderwellenelektrode bilden vorzugsweise ein Liniengitter. Sie besitzen sämtlich die gleiche Größe und Form, zum Beispiel eine gerade Form oder eine gekrümmte Linienform, und eine konstante Schrittweite (konstante gegenseitige Abstände von Mitte zu Mitte benachbarter Streifenelektroden). Die Verwendung gerader Elektrodenstreifen besitzt Vorteile für die Homogenität der Wanderwellen für den Partikeltransport.

Allgemein können die Streifenelektroden jeweils einstückig gebildet sein. Alternativ ist die Bildung eines Elektrodenstreifens durch eine Reihe von miteinander elektrisch verbundenen, zum Beispiel quadratischen Elektrodensegmenten möglich, wie sie von herkömmlichen adaptiven Elektroden bekannt sind.

Gemäß einer bevorzugten Ausführungsform der erfindungsgemäßen Plasmaeinrichtung weist die Wanderwellenelektrode einen plattenförmigen Elektrodenträger auf, wobei die Streifenelektroden auf mindestens einer Oberfläche des Elektrodenträgers angeordnet sind. Die Bereitstellung des Elektrodenträgers besitzt den Vorteil, dass ein kompaktes Bauteil mit einer definierten Anordnung der Streifenelektroden geschaffen wird. Insbesondere für Anwendungen zur plasmabasierten Materialabscheidung kann es vorteilhaft sein, wenn auf beiden Oberflächen des Elektrodenträgers Streifenelektroden angeordnet sind. Dies ermöglicht eine Beschichtungsanordnung mit zwei vertikal angeordneten Substraten, zwischen denen die Wanderwellenelektrode zum Abtransport von Teilchen über beiden Elektrodenoberflächen angeordnet ist.

Gemäß bevorzugten Ausführungsformen der Erfindung umfassen die Streifenelektroden Drahtelektroden, die voneinander isoliert in den Elektrodenträger eingelassen oder auf dessen Oberfläche angeordnet sind. Drahtelektroden besitzen den Vorteil, dass sie mit einem besonders geringen Abstand angeordnet werden können. Dies wirkt sich positiv auf die Einstellung einer im Wesentlichen glatten und stufenlosen Wellenform der Wanderwellen aus. Des weiteren besitzen Drahtelektroden Vorteile in Bezug auf die Freiheit bei der Gestaltung der Elektrodenanordnung. Alternativ sind die Elektrodenstreifen schichtförmig auf der Oberfläche des Elektrodenträgers gebildet. Die schichtförmige Gestaltung ist wegen der in diesem Fall verminderten kapazitiven Kopplung zwischen benachbarten Elektrodenstreifen von Vorteil.

Zur Realisierung der o. g. kreisförmigen Bewegung der Partikel weist die Wanderwellenelektrode einen ringförmigen Elektrodenträger auf, auf dessen Oberfläche die Streifenelektroden angeordnet sind. Die ringförmige Streifenelektrode ermöglicht vorteilhafterweise eine weitere Anwendung des erfindungsgemäßen Partikeltransports mittels Wanderwellen, wobei eine Partikelbeschleunigung im Plasma z. B. durch eine Erhöhung der Wanderungsgeschwindigkeit von Wanderwellen in einem oder mehreren, nebeneinander angeordneten Ringen von Streifenelektroden erfolgt.

Gemäß einer weiteren Variante der Erfindung umfasst die Wanderwellenelektrode Streifenelektrodengruppen jeweils mit einer Vielzahl von Streifenelektroden. Die zu einer Streifenelektrodengruppe gehörenden Streifenelektroden sind elektrisch miteinander verbunden. Die Streifenelektroden sind so angeordnet, dass die Streifenelektroden aufeinanderfolgend jeweils zu einer anderen Streifenelektrodengruppe gehören. Mit der Anordnung der Streifenelektroden wird ein periodisches Muster bereitgestellt, wobei die Perioden jeweils in derselben Reihenfolge eine Streifenelektrode jeder Streifenelektrodengruppe enthalten. Die Zusammenfassung von Streifenelektroden zu Gruppen ermöglicht vorteilhafterweise, dass alle zu einer Streifenelektrodengruppe gehörenden Streifenelektroden mit derselben Phasenlage der Sammlungswechselspannung beaufschlagt werden. Durch die genannten Perioden wird gerade die Ausdehnung einer Periode der elektrischen Wanderwellen definiert.

Wenn die Wanderwellenelektrode gemäß einer weiteren Modifikation der Erfindung mit einer Heizeinrichtung ausgestattet ist, kann dies Vorteile bei der Herstellung polymorpher Schichten, z. B. für Solarzellen auf Si-Basis, und/oder zum Schutz der Streifenelektroden vor Deposition aufweisen. Erfindungsgemäß können die kleineren Partikel aus dem Plasma abtransportiert werden, während die größeren Partikel auf dem Substrat abgeschieden werden. Diese größeren Partikel können dann durch das Heizen des Substrates mit der Heizeinrichtung zum weiteren kristallographischen Wachstum angeregt oder einem Ausheilvorgang unterzogen werden.

Weitere Einzelheiten und Vorteile werden im folgenden unter Bezug auf die beigefügten Zeichnungen beschrieben. Es zeigen:
- Fig. 1:: eine schematische Darstellung einer ersten Ausführungsform einer erfindungsgemäßen Plasmaeinrichtung,
- Fig. 2:: Kurvendarstellungen mit Beispielen erfindungsgemäß verwendeter Sammlungswechselspannungen,
- Fig. 3:: Ausführungsformen erfindungsgemäß verwendeter Streifenelektroden,
- Fig. 4:: eine Illustration der Bildung von Streifenelektrodengruppen,
- Fign. 5: und 6: Einzelheiten von weiteren Ausführungsformen erfindungsgemäßer Plasmaeinrichtungen mit vertikal ausgerichteten Hauptelektroden,
- Fig. 7:: eine schematische Draufsicht einer weiteren Ausführungsform einer erfindungsgemäßen Plasmaeinrichtung mit ringförmig angeordneten Streifenelektroden, und
- Fig. 8:: eine perspektivische Schnittdarstellung der Anordnung von Streifenelektroden bei der Ausführungsform gemäß Fig. 7.

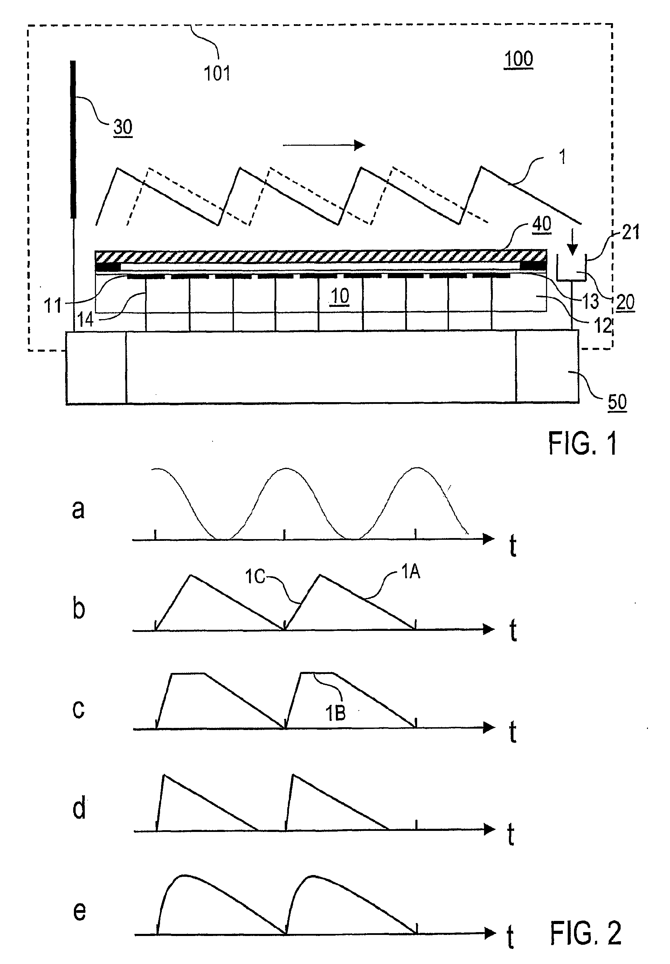

Einzelheiten des erfindungsgemäßen Verfahrens werden im folgenden unter Bezug auf die in Figur 1 gezeigte Plasmaeinrichtung 100 erläutert. Bekannte Einzelheiten von der Plasmaeinrichtung und deren Betrieb, insbesondere die Betriebsbedingungen zur Erzeugung eines Plasmas werden hier nicht beschrieben.

Figur 1 zeigt schematisch die Plasmaeinrichtung 100 mit einer Wanderwellenelektrode 10, einem Sammlungsbereich 20, einer Gegenelektrode 30, einem Substrat 40 und einer Steuereinrichtung 50. Die genannten Komponenten 10 bis 40 sind in einer evakuierbaren Plasmakammer 101 (gestrichelt illustriert) angeordnet. In der Plasmakammer 101 kann in einem Betriebsgas ein Plasmazustand gezündet werden. In dem Plasma können sich Partikel bilden, oder es können Partikel von außen in das Plasma zugeführt werden. Die Partikel besitzen Größen im Bereich zum Beispiel von 10 nm bis 20 µm.

Die Wanderwellenelektrode 10 umfasst eine Vielzahl von Elektrodenstreifen 11, die auf einem plattenförmigen Elektrodenträger 12 angeordnet und jeweils über einen Elektrodenanschluss 14 mit der Steuereinrichtung 50 verbunden sind. In Figur 1 sind zu Illustrationszwecken die Streifenelektroden 11 nicht maßstabsgerecht eingezeichnet. Zur Erzielung möglichst stufenloser Wanderwellen und eine möglichst geringen kapazitiven Kopplung zwischen benachbarten Streifenelektroden werden diese mit einer möglichst geringen Dicke und einem möglichst geringen Abstand angeordnet. Die in Schnittdarstellung gezeigten, sich senkrecht zur Zeichenebene erstreckenden geraden Streifenelektroden 11 besitzen bspw. eine Breite von 4 mm und einen senkrechten Mitte-Mitte-Abstand von 10 mm.

Die Elektrodenanschlüsse 14 sind bspw. am Rand des Elektrodenträgers 12 an die einzelnen Elektrodenstreifen 11 angeschlossen. Über den Elektrodenstreifen 11 befindet sich eine elektrisch isolierende Schutzschicht 13 z. B. aus SiO₂ (Glas), über der das Substrat 40 angeordnet ist. Das Substrat 40 kann unmittelbar auf der Schutzschicht 13 aufliegen oder (wie dargestellt) mit Abstandshaltern mit einem Abstand vom Elektrodenträger 12 angeordnet sein.

Der Sammlungsbereich 20 umfasst eine sich parallel zum Rand des Substrats 40 erstreckende Hohlkathode 21, die ebenfalls mit der Steuereinrichtung 50 verbunden ist. Die Hohlkathode 21 besitzt z. B. die Bauart, die in WO 01/01467 beschrieben ist.

Die Wanderwellenelektrode 10 dient bei der Ausführungsform gemäß Figur 1 gleichzeitig als Leistungselektrode, die mit der Gegenelektrode 30 zur Bildung des Plasmas in der Plasmaeinrichtung 100 zusammenwirkt. Die Gegenelektrode 30 kann als ring-, scheiben- oder stabförmige Elektrode in der Plasmakammer 101 angeordnet sein oder alternativ durch die Wand der Plasmakammer 101 gebildet werden. Das Substrat 40 ist in Abhängigkeit von der Anwendung der Plasmaeinrichtung 100 gewählt und besteht zum Beispiel aus einem Halbleiterwafer oder Glas.

In der Steuereinrichtung 50 ist eine Spannungsquelle zur Bereitstellung der Sammlungswechselspannung mit einem vorbestimmten Spannungsverlauf vorgesehen, die mit definierten Phasenverschiebungen den Streifenelektroden 11 aufgeprägt wird. Die Spannungsquelle dient auch der Bereitstellung der Betriebsspannung zur Erzeugung des Plasmas in der Plasmakammer 101. Beispielsweise werden alle Streifenelektroden unter Verwendung geeigneter Frequenzfilter gemeinsam mit einer hochfrequenten Betriebsspannung beaufschlagt.

In Figur 1 ist schematisch beispielhaft ein rampenförmiger Spannungsverlauf 1 zu zwei verschiedenen Zeitpunkten gezeigt. Da die Sammlungswechselspannung an den Streifenelektroden 11 aufeinanderfolgend mit einer zunehmenden Verzögerung oder Phasenverschiebung bereitgestellt wird, ergibt sich das Bild einer rampenförmigen Feldverteilung, die sich im Zeitverlauf wellenartig hin zum Sammlungsbereich 20 bewegt (s. oberer Pfeil). Es entsteht ein sich parallel zur Oberfläche des Elektrodenträgers erstreckender Feldgradient. Partikel, die bspw. durch Keimwachstum im Plasma oberhalb des Substrats 40 gebildet werden und wachsen, erfahren durch die Wanderwelle eine Kraftwirkung zum Rand des Substrats 40, wo sie mit der Hohlkathode 21 aufgenommen oder "aufgesaugt" werden.

Figur 2 illustriert verschiedene Varianten symmetrischer oder asymmetrischer Spannungsverläufe der Sammlungswechselspannung. Es sind jeweils die Amplituden der Wechselspannungsanteile gezeigt, mit denen die Streifenelektroden 11 beaufschlagt werden. Figur 2a zeigt einen sinusförmigen Verlauf der Sammlungswechselspannung, der eine Wanderwelle mit gleichen ansteigenden und abfallenden Flanken ergibt. Die übrigen Verläufe in den Figuren2b - 2e zeigen asymmetrische Formen mit einer langsam ansteigenden Vorderflanke 1A, ggf. einem Gleichspannungsbereich 1B und einer schnell abfallenden Rückflanke 1C. Die Flanken 1A, 1C in Figur 2b besitzen bspw. ein Zeitverhältnis von 10:1. Dieses kann bei gleichbleibender Periode der Sammlungswechselspannung durch die Einfügung der Gleichspannungsbereiche 1B variiert werden (Figuren 2c, d). Figur 2e illustriert, dass der Spannungsverlauf 1 nicht zwingend aus linearen Kurvenstücken zusammengesetzt sein muss, sondern auch jede andere Zeitabhängigkeit besitzen kann.

Die Amplitude, Frequenz, Kurvenform (insbesondere Steilheit der Flanken) und Phase der Sammlungswechselspannung und damit insbesondere die Propagationsgeschwindigkeit der Wanderwelle werden mit der Spannungsquelle in der Steuereinrichtung 50 vorgegeben. Wenigstens eine dieser Größen ist mit der Spannungsquelle wählbar. Beispielsweise kann durch die Wahl der Steilheit der abfallenden Flanke 1C die Partikelgröße festgelegt werden, oberhalb derer im wesentlichen kein Partikeltransport erfolgt. Die konkreten quantitativen Größen wählt der Fachmann insbesondere in Abhängigkeit vom Partikelmaterial, den Partikelgrößen und den Feldstärken.

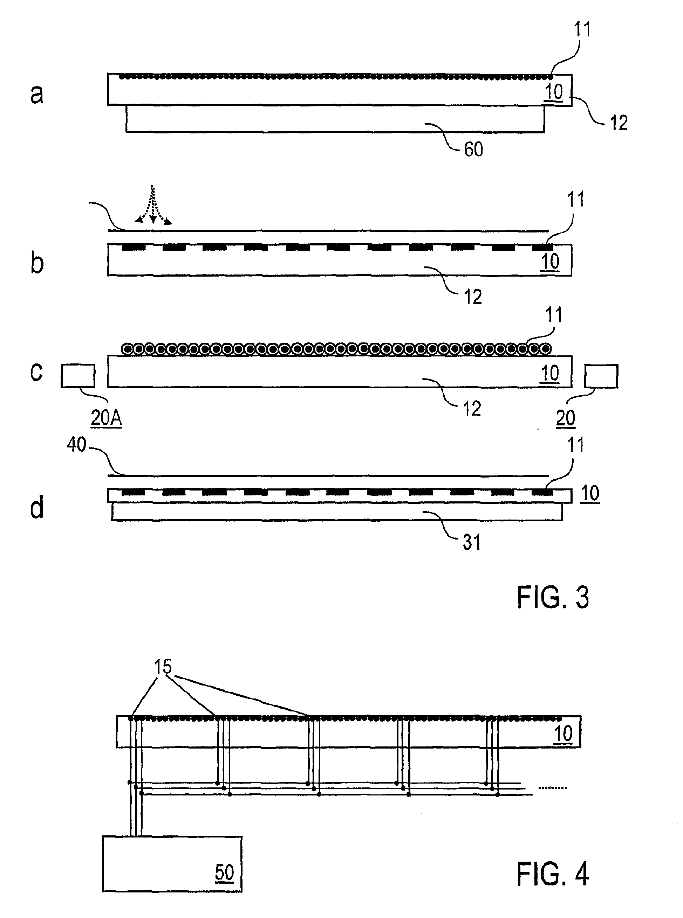

Figur 3 illustriert verschiedene Varianten einer Wanderwellenelektrode 10 mit den Streifenelektroden 11 in oder auf dem Elektrodenträger 12, jeweils beispielhaft mit weiteren Merkmalen der Erfindung. Gemäß Figur 3a sind Drahtelektroden in die Oberfläche des Elektrodenträgers 12 eingebettet. Figur 3a illustriert auch die Kombination der erfindungsgemäßen Wanderwellenelektrode 10 mit einer Heizeinrichtung 60, die mit dem Elektrodenträger 12 in thermischer Verbindung steht und beispielsweise auf dessen Unterseite angeordnet ist. Figur 3b zeigt eine Variante mit Streifenelektroden 11 in Form gerader Elektrodenbänder (Schnittdarstellung). Im linken Teil von Figur 3b ist die Wirkung einer hochfrequenten Modulationsspannung gezeigt, die der Sammlungswechselspannung überlagert ist. Während des Durchlaufes der Wanderwelle werden Ionen im Plasma unter der Wirkung der Modulationsspannung auf einen Bereich verteilt, der sich über zwei benachbarte Streifenelektroden erstreckt. Damit wird die Beschichtung eines Substrates 40 homogenisiert. Gemäß Figur 3c sind die Streifenelektroden 11 jeweils durch isolierte oder in ein nichtleitendes Material, z. B. einen Harz eingebettete Drähte gebildet, die auf der Oberfläche des Elektrodenträgers 12 angeordnet sind. Die Beschichtung der Streifenelektroden 11, die in Fig. 3c beispielhaft gezeigt ist, kann auch für den Schutz der Streifenelektroden vor unerwünschter Deposition von Vorteil sein. Figur 3c illustriert ferner beispielhaft die Anordnung von zwei Sammlungsbereichen 20, 20A auf verschiedenen Seiten des Elektrodenträgers.

Figur 3d zeigt einen Aufbau mit einem zu beschichtenden Substrat 40 ähnlich zu Fig. 3b, wobei in diesem Fall jedoch zusätzlich zur Wanderwellenelektrode 10 eine separate Leistungselektrode 31 vorgesehen ist, die mit der Betriebsspannung zur Bildung des Plasmazustands in der Plasmaeinrichtung beaufschlagt wird. Hierzu besitzen die Streifenelektroden 11 und die Leistungselektrode 31 getrennte Anschlussleitungen (nicht dargestellt) zur Verbindung mit der Steuereinrichtung 50.

Figur 4 illustriert schematisch die Bildung von Elektrodenstreifengruppen 15, bei denen aufeinanderfolgend Elektrodenstreifen 11 periodisch miteinander verbunden sind. Beim dargestellten Beispiel werden die 1., 16., 32. etc. Elektrodenstreifen 11 elektrisch miteinander verbunden und mit derselben Phasenlage der Sammlungswechselspannung beaufschlagt, während die jeweils folgende 2., 17. und 33. Streifenelektrode ebenfalls mit einer gemeinsamen, gegenüber der ersten Phasenlage jedoch verzögerten Phase beaufschlagt werden. Entsprechend muss mit der Steuereinrichtung 50 der Spannungsverlauf der gewünschten Sammlungswechselspannung lediglich mit 15 verschiedenen Phasenlagen bereitgestellt werden, um die sich über das gesamte Substrat bewegende Wanderwelle zu erzeugen.

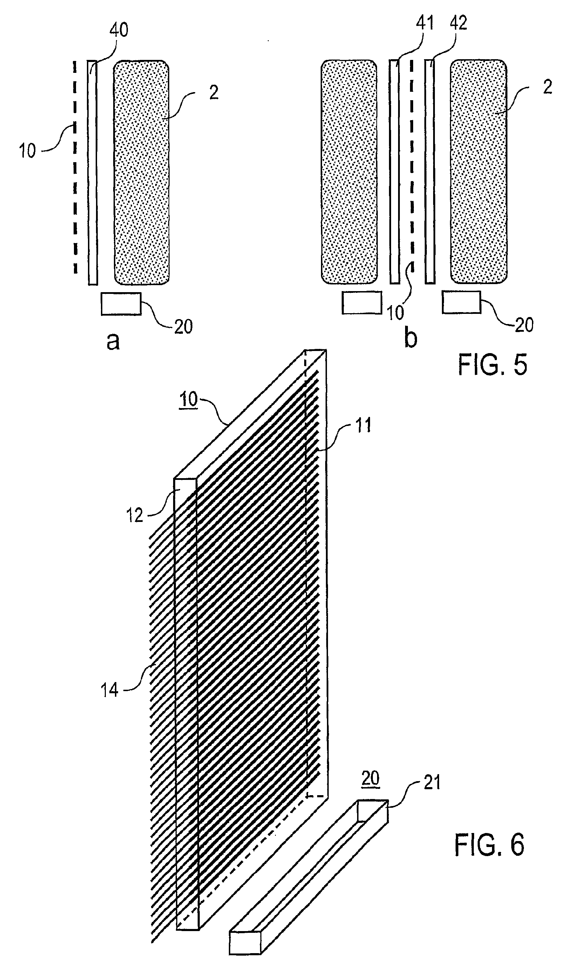

Die Figuren 5a und 5b zeigen die Anwendung der Erfindung bei der plasmabasierten Materialabscheidung auf dem Substrat 40. Gemäß Figur 5a befindet sich die Wanderwellenelektrode 10 auf der vom Plasma 2 abgewandten Seite des vertikal ausgerichteten Substrats 40. Die Wanderwellen werden parallel zur Substratoberfläche zum unteren Rand des Substrats vertikal nach unten laufend erzeugt. Figur 5b zeigt die für praktische Anwendungen bedeutsame zweiseitige Nutzung der Wanderwellenelektrode 10, die hier zwischen zwei Substraten 41, 42 angeordnet ist.

Figur 6 illustriert die erfindungsgemäße Kombination der Wanderwellenelektrode 10 und des Sammlungsbereiches 20 in schematischer Perspektivansicht mit weiteren Einzelheiten. Die Streifenelektroden 11 sind in den Elektrodenträger 12 eingebettet. Die elektrische Verbindung erfolgt über die Elektrodenanschlüsse 14 am Rand des Elektrodenträgers 12. Die Hohlkathode 21 des Sammlungsbereiches 20 erstreckt sich über die gesamte Länge der Streifenelektroden 11 am Rand des Elektrodenträgers 12.

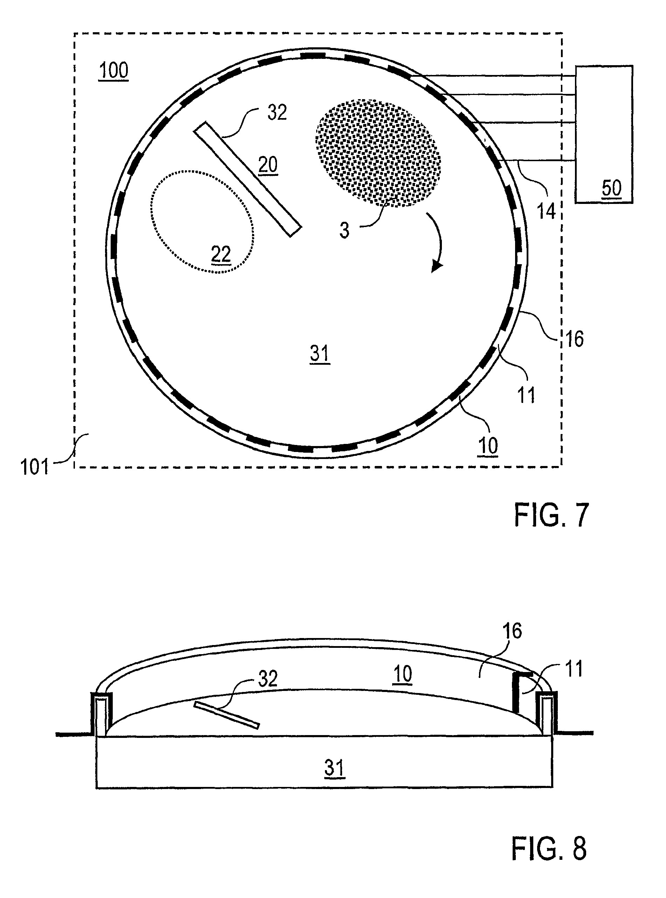

Eine weitere abgewandelte Ausführungsform der Erfindung, bei der kreisförmige Partikelbewegungen erzeugt werden, ist schematisch in den Figuren 7 und 8 illustriert. Gemäß Figur 7 ist in der Plasmaeinrichtung 100 mit der evakuierbaren Plasmakammer 101 eine schematisch in Draufsicht gezeigte Leistungselektrode 31 vorgesehen, an deren Umfangsrand sich die Wanderwellenelektrode 10 mit einer Vielzahl von Elektrodenstreifen 11 auf einem ringförmigen Elektrodenträger 16 erstreckt. Die Leistungselektrode 31 enthält einen Ausschnitt 32, an dem der Sammlungsbereich 20 gebildet ist. Figur 8 zeigt einen entsprechenden Aufbau in geschnittener Perspektivansicht. Jede der Streifenelektroden 11 ist mit der Steuereinrichtung 50 verbunden, welche die Spannungsquelle zur Erzeugung der Sammlungswechselspannung und der Modulationsspannung enthält. Aus Übersichtlichkeitsgründen sind in Figur 7 nicht alle Elektrodenanschlüsse 14 der einzelnen Streifenelektroden 11 und in Figur 8 nicht alle Streifenelektroden gezeigt.

Bei der in den Figuren 7 und 8 gezeigten Ausführungsform werden kreisförmig laufende Wanderwellen erzeugt, mit denen die Partikel 3 im Plasma über der Leistungselektrode 31 auf Kreisbahnen bewegt werden. Die Bewegung erfolgt bis zum Ausschnitt 32, an dem bspw. mit einer Hohlkathode (nicht dargestellt) die Partikel aus der Plasmakammer abgesaugt werden.

Figur 7 zeigt auch schematisch eine Anreicherungszone 22, die einen Raumbereich in der Plasmakammer umfasst, in dem durch eine entsprechende Ansteuerung der benachbarten Elektroden oder durch das Fehlen von Elektroden Bedingungen derart gegeben sind, dass sich die Partikel 3 in diesem Raumbereich sammeln.

Da am radial äußeren Rand der Leistungselektrode 31 der Partikeltransport mit einer höheren Effektivität erfolgt, ist die Kreisbewegung der Partikel mit einer radial nach außen gerichteten Diffusionsbewegung von Partikeln überlagert.

Ein wichtiger Vorteil der in den Figuren 7 und 8 gezeigten Ausführungsform der Erfindung besteht darin, dass mit dem ringförmigen Elektrodenträger 16 bestehende Plasmareaktoren einfach nachgerüstet werden können. Um die Streifenelektroden 11 beim Betrieb der Plasmaeinrichtung vor einer Deposition zu schützen, kann eine Heizeinrichtung zum Heizen der Streifenelektroden 11 und/oder eine Beschichtung der Streifenelektroden 11, z. B. mit Glas vorgesehen sein.

Ein weiterer Vorteil der gezeigten Ausführungsform besteht in der Möglichkeit, einen kontinuierlichen Partikelfluss mit einer konstanten oder einer variablen Geschwindigkeit in der Plasmaeinrichtung zu erzeugen, um die Wechselwirkungen zwischen den Partikeln zu untersuchen, die sog. flüssige oder kristalline Zustände bilden.

Die in der vorstehenden Beschreibung, den Zeichnungen und den Ansprüchen offenbaren Merkmale der Erfindung können sowohl einzeln als auch in Kombination für die Verwirklichung der Erfindung in ihren verschiedenen Ausgestaltungen von Bedeutung sein.

## Patentansprüche

1. Verfahren zum Betrieb einer Plasmaeinrichtung (100), in der in einem Plasma Partikel (2) angeordnet sind, bei dem
- eine Erzeugung von elektrischen Wanderwellen (1) vorgesehen ist, unter deren Wirkung die Partikel (2) in der Plasmaeinrichtung (100) eine gerichtete Bewegung zu mindestens einem vorbestimmten Sammlungsbereich (20, 20A) ausführen, wobei
- zur Erzeugung der elektrischen Wanderwellen (1) eine Vielzahl von Streifenelektroden (11) in der Plasmaeinrichtung (100) mit mindestens einer Sammlungswechselspannung beaufschlagt werden,
wobei
- die Sammlungswechselspannung eine Frequenz aufweist, die geringer als die Frequenz einer Betriebs-Wechselspannung einer Plasmaentladung zur Bildung des Plasmas ist, **dadurch gekennzeichnet, dass** die Frequenz der Sammlungswechselspannung im Bereich von 0.01 Hz bis 10 Hz gewählt ist.

2. Verfahren nach Anspruch 1, bei dem die Streifenelektroden (11) mit der Sammlungswechselspannung jeweils mit einer vorbestimmten Phasenverschiebung beaufschlagt werden.

3. Verfahren nach mindestens einem der Ansprüche 1 oder 2, bei dem die Sammlungswechselspannung mit einem symmetrischen Spannungsverlauf bereitgestellt wird, der innerhalb einer Periode jeweils zwei zueinander symmetrische Flanken enthält.

4. Verfahren nach mindestens einem der Ansprüche 1 oder 2, bei dem die Sammlungswechselspannung mit einem asymmetrischen Spannungsverlauf bereitgestellt wird, der innerhalb einer Periode jeweils zwei Flanken mit verschiedenen Steilheiten enthält.

5. Verfahren nach Anspruch 3 oder 4, bei dem die Sammlungswechselspannung innerhalb einer Periode jeweils mindestens einen Gleichspannungsabschnitt enthält.

6. Verfahren nach mindestens einem der Ansprüche 3 bis 5, bei dem die Steilheit und/oder Dauer der Flanken so gewählt wird, dass ausschließlich Partikel mit einer Größe unterhalb einer vorbestimmten Maximalgröße die gerichtete Bewegung ausführen.

7. Verfahren nach mindestens einem der vorhergehenden Ansprüche, bei dem die Sammlungswechselspannung mit einer höherfrequenten Modulationsspannung überlagert wird.

8. Verfahren nach mindestens einem der vorhergehenden Ansprüche, bei dem die Streifenelektroden (11) mit der Sammlungswechselspannung und einer Betriebsspannung der Plasmaeinrichtung beaufschlagt werden.

9. Verfahren nach Anspruch 7 und 8, bei dem die höherfrequente Modulationsspannung eine Frequenz im Bereich von 0.1 kHz bis 100 kHz aufweist.

10. Verfahren nach mindestens einem der vorhergehenden Ansprüche, bei dem die Streifenelektroden (11) mit der Sammlungswechselspannung und eine separate Leistungselektrode (31) mit einer Betriebsspannung der Plasmaeinrichtung beaufschlagt werden.

11. Verfahren nach Anspruch 7 und 10, bei dem die höherfrequente Modulationsspannung eine Frequenz im Bereich von 10 kHz bis 1 MHz aufweist.

12. Verfahren nach mindestens einem der vorhergehenden Ansprüche, bei dem eine Erzeugung von elektrischen Wanderwellen (1) mit zueinander entgegengesetzten Richtungen derart vorgesehen ist, dass die Partikel (2) gerichtete Bewegungen zu zwei vorbestimmten Sammlungsbereichen (20, 20A) ausführen.

13. Verfahren nach mindestens einem der vorhergehenden Ansprüche, bei dem die Partikel in dem Sammlungsbereich (20) mit einer Hohlkathode (21) aufgenommen werden.

14. Verfahren nach mindestens einem der vorhergehenden Ansprüche, bei dem der Sammlungsbereich (20) eine Anreicherungszone (22) umfasst, in der die Partikel im Plasma angereichert werden.

15. Verfahren nach mindestens einem der vorhergehenden Ansprüche, bei dem die Partikel eine gerichtete Linearbewegung oder eine gerichtete Kreisbewegung ausführen.

16. Plasmaeinrichtung (100) zur Bildung eines Plasmas, die umfasst:
- eine Wanderwellenelektrode (10) zur Erzeugung von elektrischen Wanderwellen (1), unter deren Wirkung Partikel (2) in der Plasmaeinrichtung (100) eine gerichtete Bewegung ausführen, und
- mindestens einen vorbestimmten Sammlungsbereich (20, 20A), zu dem die gerichtete Bewegung der Partikel führt, wobei
- die Wanderwellenelektrode (10) eine Vielzahl von Streifenelektroden (11) aufweist, die mit einer Spannungsquelle zur Erzeugung mindestens einer Sammlungswechselspannung verbunden sind, mit der die Streifenelektroden (11) beaufschlagt werden können, und wobei
- die Spannungsquelle zur Erzeugung der Sammlungswechselspannung mit einer Frequenz eingerichtet ist, die geringer als die Frequenz einer Hochfrequenz-Wechselspannung zur Erzeugung des Plasmas ist, **dadurch gekennzeichnet, dass** die Frequenz der Spannungsquelle zur Erzeugung der Sammlungswechsclspannung im Bereich von 0.01 Hz bis 10 Hz gewählt ist.

17. Plasmaeinrichtung nach Anspruch 16, bei der die Spannungsquelle eine Phasenschiebereinrichtung enthält, die zur Beaufschlagung der Streifenelektroden (11) mit der Sammlungswechselspannung jeweils mit einer vorbestimmten Phasenlage eingerichtet ist.

18. Plasmaeinrichtung nach Anspruch 16 oder 17, bei der die Spannungsquelle zu Erzeugung der Sammlungswechselspannung mit wenigstens einem der folgenden Spannungsverläufe eingerichtet ist:
- symmetrischer Spannungsverlauf, der innerhalb einer Periode jeweils zwei zueinander symmetrische Flanken enthält,
- asymmetrischer Spannungsverlauf, der innerhalb einer Periode jeweils zwei Flanken mit verschiedenen Steilheiten enthält, und
- Spannungsverlauf, der innerhalb einer Periode jeweils einen Gleichspannungsbereich enthält.

19. Plasmaeinrichtung nach Anspruch 18, bei der die Spannungsquelle zur Auswahl der Steilheit und/oder Dauer der Flanken steuerbar ist.

20. Plasmaeinrichtung nach mindestens einem der Ansprüche 16 bis 19, bei der die Spannungsquelle zur Erzeugung einer höherfrequenten Modulationsspannung zur Überlagerung mit der Sammlungswechselspannung eingerichtet ist.

21. Plasmaeinrichtung nach mindestens einem der Ansprüche 16 bis 20, bei der die Spannungsquelle zur Erzeugung einer Betriebswechselspannung der Plasmaeinrichtung zur Plasmaerzeugung eingerichtet ist und die Wanderwellenelektrode (10) mit der Betriebswechselspannung beaufschlagt wird.

22. Plasmaeinrichtung nach mindestens einem der Ansprüche 16 bis 21, die eine separate Leistungselektrode (31) enthält, die mit einer Betriebswechselspannung der Plasmaeinrichtung zur Plasmaerzeugung beaufschlagt wird.

23. Plasmaeinrichtung nach mindestens einem der Ansprüche 16 bis 22, bei welcher der Sammlungsbereich (20, 20A) eine Hohlkathode (21) aufweist.

24. Plasmaeinrichtung nach mindestens einem der Ansprüche 16 bis 23, bei welcher der Sammlungsbereich (20, 20A) eine Anreicherungszone (22) aufweist, in der die Partikel im Plasma angereichert werden.

25. Plasmaeinrichtung nach mindestens einem der Ansprüche 16 bis 24, bei der die Wanderwellenelektrode (10) einen plattenförmigen Elektrodenträger (12) aufweist, wobei die Streifenelektroden (11) auf wenigstens einer Oberfläche des plattenförmigen Elektrodenträgers (12) angeordnet sind.

26. Plasmaeinrichtung nach Anspruch 25, bei der die Streifenelektroden (11) auf beiden Oberflächen des plattenförmigen Elektrodenträgers (12) angeordnet sind.

27. Plasmaeinrichtung nach Anspruch 25 oder 26, bei der die Streifenelektroden (11) Drahtelektroden oder Elektrodenbänder umfassen.

28. Plasmaeinrichtung nach mindestens einem der Ansprüche 16 bis 27, bei der die Wanderwellenelektrode (10) einen ringförmigen Elektrodenträger (16) aufweist, wobei die Streifenelektroden (11) auf wenigstens einer Oberfläche des ringförmigen Elektrodenträgers (16) angeordnet sind.

29. Plasmaeinrichtung nach mindestens einem der Ansprüche 16 bis 28, die eine Vielzahl von Streifenelektrodengruppen (15) aufweist, wobei die zu einer Streifenelektrodengruppe (15) gehörenden Streifenelektroden (11) jeweils elektrisch miteinander verbunden sind, so dass sie mit der Sammlungswechselspannung jeweils mit der selben Phasenlage beaufschlagt werden können.

30. Plasmaeinrichtung nach mindestens einem der Ansprüche 16 bis 29, bei der eine Heizeinrichtung (60) vorgesehen ist, mit der die Wanderwellenelektrode (10) temperierbar ist.

31. Verwendung eines Verfahrens oder einer Plasmaeinrichtung nach mindestens einem der vorhergehenden Ansprüche, zur:
- Abführung von Partikeln aus einer Plasmaeinrichtung,
- Erzeugung einer Partikelwolke mit einer vorbestimmten Partikelgrößenverteilung, oder
- Abscheidung von Partikeln auf Substraten bei der Herstellung von polymorphen Solarzellen.

## Claims

1. A method for the operation of a plasma device (100) in which particles (2) are arranged in a plasma, wherein
- a generation of electric travelling waves (1) is provided under whose effective action the particles (2) in the plasma device (100) perform a directed movement to at least one pre-determined collection area (20, 20A), wherein
- for the generation of the electric travelling waves (1), a plurality of strip electrodes (11) in the plasma device (100) are loaded with at least one collection alternating voltage, wherein
- the collection alternating voltage has a frequency that is less than the frequency of an operating alternating voltage of a plasma discharging for the creation of the plasma,
**characterized in that**
- the frequency of the collection alternating voltage is selected in the range from 0,01 Hz to 10 Hz.

2. The method according to claim 1, wherein the strip electrodes (11) are loaded with the collection alternating voltage in each case with a pre-determined phase shift.

3. The method according to at least one of the claims 1 or 2, wherein the collection alternating voltage is provided with a symmetrical voltage characteristic which contains in each case two edges symmetrical to one another within one period.

4. The method according to at least one of the claims 1 or 2, wherein the collection alternating voltage is provided with an asymmetrical voltage characteristic which contains in each case two edges with different steepnesses within one period.

5. The method according to claim 3 or 4, wherein the collection alternating voltage contains in each case at least one direct voltage section within a period.

6. The method according to at least one of the claims 3 to 5, wherein the steepness and/or the duration of the edges are selected in such a way that, exclusively, particles with a size below a pre-determined maximum size perform the directed movement.

7. The method according to at least one of the preceding claims, wherein the collection alternating voltage is superimposed with a higher frequent modulation voltage.

8. The method according to at least one of the preceding claims, wherein the strip electrodes (11) are loaded with the collection alternating voltage and an operating voltage of the plasma device.

9. The method according to claim 7 and 8, wherein the higher frequent modulation voltage has a frequency in the range from 0.1 kHz to 100 kHz.

10. The method according to at least one of the preceding claims, wherein the strip electrodes (11) are loaded with the collection alternating voltage and a separate power electrode (31) is loaded with an operating voltage of the plasma device.

11. The method according to claims 7 and 10, wherein the higher frequent modulation voltage has a frequency in the range from 10 kHz to 1 MHz.

12. The method according to at least one of the preceding claims, wherein a generation of the electric travelling waves (1) is provided with directions opposing one another in such a way that the particles (2) perform directed movements to two pre-determined collection areas (20, 20A).

13. The method according to at least one of the preceding claims, wherein the particles in the collection area (20) are taken up by a hollow cathode (21).

14. The method according to at least one of the preceding claims, wherein the collection area (20) comprises an enrichment zone (22) in which the particles in the plasma are accumulated.

15. The method according to at least any one of the preceding claims, wherein the particles perform an aligned linear movement or an aligned circular movement.

16. A plasma device (100) for the creation of a plasma, comprising
- a travelling wave electrode (10) for the generation of electric travelling waves (1) under whose effective action particles (2) in the plasma device (100) perform a directed movement, and
- at least one pre-determined collection area (20, 20A), to which the directed movement of the particles leads, wherein
- the travelling wave electrode (10) has a plurality of strip electrodes (11) which are connected to a voltage source for the generation of at least one collection alternating voltage, with which the strip electrodes (11) can be loaded, and wherein
- the voltage source is configured for the generation of the collection alternating voltage with a frequency that is less than the frequency of a high-frequent alternating voltage for the creation of the plasma,
**characterized in that**
- the frequency of the voltage source for the generation of the collection alternating voltage is selected in the range from 0,01 Hz to 10 Hz.

17. The plasma device according to claim 16, wherein the voltage source contains a phase shift device which is configured for loading the strip electrodes (11) with the collection alternating voltage, in each case with a pre-determined phase position.

18. The plasma device according to claims 16 or 17, wherein the voltage source for generating the collection alternating voltage is configured with at least one of the following voltage characteristics:
- symmetrical voltage characteristic which contains two edges symmetrical to one another within one period,
- asymmetrical voltage characteristic which contains two edges with different steepnesses within one period, and
- voltage characteristic which contains one direct voltage area within one period.

19. The plasma device according to claim 18, wherein the voltage source is controllable for the selection of the steepness and/or the duration of the edges.

20. The plasma device according to at least one of the claims 16 to 19, wherein the voltage source is configured for generating a higher frequent modulation voltage for superimposition with the collection alternating voltage.

21. The plasma device according to at least one of the claims 16 to 20, wherein the voltage source is configured for generating an operating alternating voltage of the plasma device for plasma creation and the travelling wave electrode (10) is loaded with the operating alternating voltage.

22. The plasma device according to at least one of the claims 16 to 21, containing a separate power electrode (31) that is loaded with an operating alternating voltage of the plasma device for the plasma creation.

23. The plasma device according to at least one of the claims 16 to 22, wherein the collection area (20, 20A) has a hollow cathode (21).

24. The plasma device according to at least one of the claims 16 to 283, wherein the collection area (20, 20A) has an enrichment zone (22) in which the particles in the plasma are accumulated.

25. The plasma device according to at least one of the claims 16 to 24, wherein the travelling wave electrode (10) has a plate-shaped electrode carrier (12), the strip electrodes (11) being arranged on at least one surface of the plate-shaped electrode carrier (12).

26. The plasma device according to claim 25, wherein the strip electrodes (11) are arranged on both surfaces of the plate-shaped electrode carrier (12).

27. The plasma device according to claim 25 or 26, wherein the strip electrodes (11) comprise wire electrodes or electrode bands.

28. The plasma device according to at least one of the claims 16 to 28, wherein the travelling wave electrode (10) has a ring-shaped electrode carrier (16), the strip electrodes (11) being arranged on at least one surface of the ring-shaped electrode carrier (16).

29. The plasma device according to at least one of the claims 16 to 28 having a plurality of strip electrode groups (15), wherein the strip electrodes (11) belonging to one strip electrode group (15) are electrically connected with one another so that they can be loaded with the collection alternating voltage with the same phase position.

30. The plasma device according to at least one of the claims 16 to 29, wherein a heating device (60) is provided, with which the travelling wave electrode (10) can be tempered.

31. The use of a method or a plasma device according to at least one of the preceding claims, for the purpose of:
- withdrawal of particles from the plasma device,
- generation of a particle cloud with a pre-determined particle size distribution, or
- deposition of particles on substrates during the manufacture of polymorphic solar cells.

## Revendications

1. Procédé de fonctionnement d'un dispositif à plasma (100) où des particules (2) sont présentes dans un plasma, où
- il est prévu une génération d'ondes électriques progressives (1), sous l'action desquelles les particules (2) exécutent un déplacement dirigé vers au moins une zone collectrice (20, 20A) déterminée dans le dispositif à plasma (100),
- au moins une tension alternative collectrice étant appliquée sur une pluralité d'électrodes à ruban (11) pour générer les ondes électriques progressives (1) dans le dispositif à plasma (100),
- la tension alternative collectrice présentant une fréquence inférieure à la fréquence d'une tension alternative de service d'une décharge de plasma pour la formation du plasma,
**caractérisé en ce que** la fréquence de la tension alternative collectrice est sélectionnée dans une plage comprise entre 0,01 Hz et 10 Hz.

2. Procédé selon la revendication 1, où la tension alternative collectrice est appliquée sur chaque électrode à ruban (11) avec un déphasage défini.

3. Procédé selon au moins une des revendications 1 ou 2, où la tension alternative collectrice est fournie avec une courbe de tension symétrique, qui comporte deux flancs symétriques l'un à l'autre à l'intérieur d'une période.

4. Procédé selon au moins une des revendications 1 ou 2, où la tension alternative collectrice est fournie avec une courbe de tension asymétrique, qui comporte deux flancs avec des pentes différentes à l'intérieur d'une période.

5. Procédé selon la revendication 3 ou la revendication 4, où la tension alternative collectrice comporte au moins une plage de tension continue à l'intérieur d'une période.

6. Procédé selon au moins une des revendications 3 à 5, où la pente et/ou la durée des flancs sont sélectionnés de telle manière que seules les particules de grandeur inférieure à une grandeur maximale définie exécutent le déplacement dirigé.

7. Procédé selon au moins une des revendications précédentes, où une tension de modulation à fréquence supérieure est superposée à la tension alternative collectrice.

8. Procédé selon au moins une des revendications précédentes, où la tension alternative collectrice et une tension de service du dispositif à plasma sont appliquées sur les électrodes à ruban (11).

9. Procédé selon les revendications 7 et 8, où la tension de modulation à fréquence supérieure présente une fréquence comprise entre 0,1 kHz et 100 kHz.

10. Procédé selon au moins une des revendications précédentes, où la tension alternative collectrice est appliquée sur les électrodes à ruban (11), et une tension de service du dispositif à plasma est appliquée sur une électrode de puissance (31) séparée.

11. Procédé selon les revendications 7 et 10, où la tension de modulation à fréquence supérieure présente une fréquence comprise entre 10 kHz et 1 MHz.

12. Procédé selon au moins une des revendications précédentes, où une génération d'ondes électriques progressives (1) de directions opposées est prévue de telle manière que les particules (2) exécutent des déplacements dirigés vers deux zones collectrices (20, 20A) déterminées.

13. Procédé selon au moins une des revendications précédentes, où les particules sont captées par une cathode creuse (21) dans la zone collectrice (20).

14. Procédé selon au moins une des revendications précédentes, où la zone collectrice (20) comprend une zone d'enrichissement (22) où les particules sont enrichies dans le plasma.

15. Procédé selon au moins une des revendications précédentes, où les particules exécutent un mouvement linéaire ou un mouvement circulaire dirigé.

16. Dispositif à plasma (100) pour la formation d'un plasma, comprenant :
- une électrode à onde progressive (10) pour la génération d'ondes électriques progressives (1), sous l'action desquelles les particules (2) exécutent un déplacement dirigé dans le dispositif à plasma (100), et
- au moins une zone collectrice (20, 20A) déterminée, où aboutit le déplacement dirigé des particules,
- l'électrode à onde progressive (10) comportant une pluralité d'électrodes à ruban (11) reliées à une source de tension pour la génération d'au moins une tension alternative collectrice pouvant être appliquée sur les électrodes à ruban (11), et
- la source de tension pour la génération de la tension alternative collectrice étant prévue avec une fréquence inférieure à la fréquence d'une tension alternative à haute fréquence pour la production du plasma,
**caractérisé en ce que** la fréquence de la source de tension pour la génération de la tension alternative collectrice est sélectionnée dans une plage comprise entre 0,01 Hz et 10 Hz.

17. Dispositif à plasma selon la revendication 16, où la source de tension comprend un dispositif déphaseur prévu pour appliquer la tension alternative collectrice sur chaque électrode à ruban (11) avec une position de phase définie.

18. Dispositif à plasma selon la revendication 16 ou la revendication 17, où la source de tension pour la génération de la tension alternative collectrice est prévue avec au moins une des courbes de tension suivantes :
- courbe de tension symétrique, qui comporte deux flancs symétriques l'un à l'autre à l'intérieur d'une période,
- courbe de tension asymétrique, qui comporte deux flancs avec des pentes différentes à l'intérieur d'une période, et
- courbe de tension comportant une plage de tension continue à l'intérieur d'une période.

19. Dispositif à plasma selon la revendication 18, où la source de tension peut être commandée pour la sélection de pente et/ou de durée des flancs.

20. Dispositif à plasma selon au moins une des revendications 16 à 19, où la source de tension est prévue pour la génération d'une tension de modulation à fréquence supérieure destinée à être superposée à la tension alternative collectrice.

21. Dispositif à plasma selon au moins une des revendications 16 à 20, où la source de tension est prévue pour la génération d'une tension alternative de service du dispositif à plasma pour la production du plasma, et où la tension alternative de service est appliquée sur l'électrode à onde progressive (10).

22. Dispositif à plasma selon au moins une des revendications 16 à 21, comprenant une électrode de puissance (31) séparée, sur laquelle est appliquée une tension alternative de service du dispositif à plasma pour la production du plasma.

23. Dispositif à plasma selon au moins une des revendications 16 à 22, où la zone collectrice (20, 20A) comporte une cathode creuse (21).

24. Dispositif à plasma selon au moins une des revendications 16 à 23, où la zone collectrice (20, 20A) comporte une zone d'enrichissement (22) où les particules sont enrichies dans le plasma.

25. Dispositif à plasma selon au moins une des revendications 16 à 24, où l'électrode à onde progressive (10) comporte un support (12) d'électrode en forme de plaque, les électrodes à ruban (11) étant disposées sur au moins une surface du support (12) d'électrode en forme de plaque.

26. Dispositif à plasma selon la revendication 25, où les électrodes à ruban (11) sont disposées sur les deux surfaces du support (12) d'électrode en forme de plaque.

27. Dispositif à plasma selon la revendication 25 ou la revendication 26, où les électrodes à ruban (11) comprennent des fils électrodes ou des bandes d'électrodes.

28. Dispositif à plasma selon au moins une des revendications 16 à 27, où l'électrode à onde progressive (10) comporte un support (16) d'électrode annulaire, les électrodes à ruban (11) étant disposées sur au moins une surface du support (16) d'électrode annulaire.

29. Dispositif à plasma selon au moins une des revendications 16 à 28, comportant une pluralité de groupes d'électrodes à ruban (15), les électrodes à ruban (11) appartenant à un groupe d'électrodes à ruban (15) étant électriquement reliées entre elles de telle manière que la tension alternative collectrice peut être appliquée sur elles avec la même position de phase.

30. Dispositif à plasma selon au moins une des revendications 16 à 29, où un dispositif de chauffage (60) est prévu, permettant la thermostatisation de l'électrode à onde progressive (10).

31. Utilisation d'un procédé ou d'un dispositif à plasma selon au moins une des revendications précédentes, pour :
- l'évacuation de particules hors d'un dispositif à plasma,
- la formation d'un nuage de particules avec une distribution de grandeurs de particules définie, ou
- le dépôt de particules sur des substrats lors de la fabrication de cellules solaires polymorphes.
